# EUROPEAN PATENT APPLICATION

(11) **EP 2 924 709 A1**
(43) Date of publication of application: **30.09.2015**
(21) Application number: 15160701.7
(22) Date of filing: 25.03.2015
(51) Int. Cl.: H01J 37/244

(54) **Imaging a sample with multiple beams and multiple detectors**

(30) Priority: 25.03.2014 EP 14161505
(71) Applicant: FEI COMPANY, Hillsboro, Oregon 97124-5793 (US)
(72) Inventor: Potocek, Pavel, 5654 PX Eindhoven (NL); Kooijman, Cornelis, 5501 BC Veldhoven (NL); Slingerland, Hendrik, 5912 TW Venlo (NL); Veen, van, Gerard, 5581 HB Waalre (NL); Boughorbel, Faysal, 5629 GA Eindhoven (NL); Faber, Pybe, 5612 DV Eindhoven (NL); Sluijterman, Albertus, 5627 WH Eindhoven (NL)
(74) Representative: Bakker, Hendrik

(57) **Abstract**

A multi-beam apparatus for inspecting or processing a sample (232) with a multitude of focused beams, the apparatus equipped to scan a multitude of N beams (240-n) over the sample, the apparatus equipped with a multitude of M detectors (234-m) for detecting secondary radiation emitted by the sample when said sample is irradiated by the multitude of beams, each of the detectors capable of outputting a detector signal representing the intensity of the secondary radiation detected by the detector, , in working, each detector signal comprising information caused by multiple beams, the information caused by one beam thus spread over multiple detectors, the apparatus equipped with a programmable controller (236) for processing the multitude of detector signals to a multitude of output signals, using weight factors so that each output signal represents information caused by a single beam, characterized in that the weight factors are dynamic weight factors depending on the scan position of the beams with respect to the detectors and the distance between sample and detectors.

The weight factors describe the contribution of each beam to each detector. The invention is based on the insight that when scanning the beams over the sample, the position of the position where the secondary radiation is formed (the impact position) changes. Therefore the weight factors should be a function of the scan position.

Also the distance between sample and detector (the working distance) has a similar effect on the weight factors

It is noted that, as the position of the impact is known at all times the weight factors can be a known function of the scan position, working distance and, if applicable, the beam energies.

## Description

### Technical field of the invention

The invention relates to a multi-beam apparatus for inspecting or processing a sample with a multitude of focused beams, the apparatus equipped to scan a multitude of N beams over the sample, the apparatus equipped with a multitude of M detectors for detecting secondary radiation emitted by the sample when said sample is irradiated by the multitude of beams, each of the detectors capable of outputting a detector signal representing the intensity of the secondary radiation detected by the detector, in working each detector signal comprising information caused by multiple beams, the information caused by one beam thus spread over multiple detectors, the apparatus equipped with a programmable controller for processing the multitude of detector signals to a multitude of output signals using weight factors, so that each output signal represents information caused by a single beam.

The invention further relates to a method of using such an apparatus.

### Background of the invention

Such an apparatus is known for US patent application number US5557105A to Fujitsu Ltd. This application describes a multi-beam electron beam inspection tool for inspection of a sample, such as a mask or a wafer or the like by irradiating multiple electron beams onto the inspection sample and detecting secondary or backscattered electrons reflected from the surface of the inspection sample and/or transmitted electrons passing through the inspection sample. The apparatus includes a detector unit having a plurality of electron detecting elements for detecting electrons containing information related to the construction of the inspection sample and a detection signal processor for processing simultaneously or in parallel formation the outputs of the electron detecting elements of the detector. When a plurality of electron beams are used for simultaneous irradiation of the inspection sample, the pattern inspection apparatus includes a mechanism for avoiding interference between the reflected electrons of adjacent electron beams.

The mechanism can be thought to operate by using weight factors representing the interference between beams, see its figure 40(a) and 40(b).

The challenge is to seek weight factors that result in minimal interference between beams.

### Summary of the invention

It is an object of the invention to provide an improved solution to this problem.

To that end the weight factors are dynamic weight factors depending on the scan position of the beams with respect to the detectors and the distance between sample and detectors.

The weight factors describe the contribution of each beam to each detector. The invention is based on the insight that when scanning the beams over the sample, the position of the position where the secondary radiation is formed (the impact position) changes. Therefore the weight factors should be a function of the scan position.

Also the distance between sample and detector (the working distance) has a similar effect on the weight factors.

Also the beam energies may influence the weight factors as the amount and direction of, for example, emitted backscattered electrons depend on the beam energies.

It is noted that, as the position of the impact is known at all times the weight factors can be a known function of the scan position and working distance.

It is further noted that each beam may be scanned independently. However, the weight factor of one beam is not influenced by the position of other beams.

In the context of this invention "(processor) output signals" may for example refer to an electric signal that is transferred to a output device such as a monitor, but may also refer to a part of a controller memory (computer memory) that is dedicated to storing information caused by one beam only, said part of a computer memory serving for display purposes or for post processing the data.
It is further noted that the programmable controller (equivalent to computer) may be a stand-alone processor (computer), or be part of a controller already included in the apparatus.

In an embodiment of the invention the beams are scanned in unison.

By scanning the beams in unison (that is: by keeping their relative position constant) the apparatus is simplified as the scan generators for all beams can have common electronics, and also the determination of the weight factors may be at least in part be determined by using 'the' scan position instead of the scan position of each beam individually.

In another embodiment the beams are beams from the group of charged particle beams, ion beams and electron beams, and combinations thereof and the weight factors are further dependent on the beam energies.

The beams with which the sample is inspected (examined, imaged) can be photonic in nature (light, UV or X-ray), but preferably comprise charged particles (for example ions or electrons). The energy of the beams influence the weight factors as, for example, the form of the envelope of backscattered electrons is energy dependent.

In another embodiment of the invention the multitude of detectors are equipped to detect visible light photons, UV photons, X-ray photons, secondary electrons, backscattered electrons, and/or combinations thereof.

In response to the irradiation by the beams the sample emits secondary radiation, such as photonic radiation (light, UV or X-rays), backscattered electrons (BSEs), secondary electrons (SEs), and secondary ions.

It is noted that the light can be reflected light, or, for example, fluorescent light, caused by impinging laser light, or the light may be fluorescent and/or phosphorescent light caused by irradiation by an electron beam. The X-rays may be caused by irradiation with electrons, as are BSEs (having an energy in excess of 50 eV). SEs (with an energy of less than 50 eV) can be emitted in response to impinging electrons, or ions, while secondary ions are typically emitted in response to impinging ions or high energy photons (ablation).

In a preferred embodiment of the invention the multitude of beams is generated by a single source.

In earlier mentioned US5,557,105A to Fujitsu Ltd. a beam module is used in which one beam is split in multiple beams, see its fig. 23 and accompanying text.

In yet another embodiment of the invention the controller is programmed to perform source separation techniques to process the multitude of detector signals so that each output signal represents information caused by a single beam.

The source separation techniques may comprise combining signals using (knowledge of) weight factors, linear system solving/inversion techniques including Gaussian elimination, blind deconvolution, etc.

It is noted that the weight factors and/or deconvolution parameters are preferably made dependent on the scan positions of the beam with respect to the sample, as changing the scan position (the position where the beam hits the sample) results in a different weight factor.

It is further noted that, although in another technical field, blind deconvolution is known from, for example, "Handbook of Blind Source Separation: Independent Component Analysis and Applications", P. Comon and C. Jutten, Academic Press, 2010 [-1-] and "Independent Component Analysis: Algorithms and Applications", A. Hyvärinen and E. Oja, Neural Networks, Vol. 13(4-5) (2000), p. 411-430 [-2-].

In an aspect of the invention a method for inspecting or processing a sample with a multi-beam apparatus, the apparatus scanning a multitude of N focused beams over the sample, the sample in response to the irradiation with the beams emitting secondary radiation, the secondary radiation detected by a multitude of M detectors, each of the M detectors outputting a detector signal representing the intensity of the secondary radiation detected by the detector, the detector signal of each detector comprising information caused by multiple beams, the information caused by one beam thus spread over multiple detectors, and the information caused by each beam is reconstructed by combining the signal of multiple detectors using weight factors, characterized in that the weight factors are dynamic weight factors depending on the scan position of the beams with respect to the detectors and the distance between sample and detectors.

In an embodiment of the method the beams are scanned in unison.

In another embodiment of the method of the invention the multitude of beams can be beams from the group of charged particle beams, ion beams and electron beams, or combinations thereof, and the weight factors are further dependent on the beam energies.

In still another embodiment of the method of the invention the secondary radiation comprises visible light photons, UV photons, X-ray photons, secondary electrons, backscattered electrons, and combinations thereof.

In yet another embodiment of the method of the invention each detector of the multitude of M detectors shares a similar response to the secondary radiation.

By using detectors sharing a similar response it is meant that the detectors have identical or almost identical response for identical input signals.

In yet another embodiment of the method of the invention scanning a multitude of N beams over the sample results in irradiating a contiguous area, and thus a contiguous area is imaged.

In yet another embodiment of the method of the invention the beams are emitted by one source.

Using one source reduces the amount of parts for the complete machine, for example the number of high voltage units, the number of lens supplies, etc. Also the intensity of the beams is easier controlled to be the same. However, it is not intended to exclude the use of an apparatus using multiple columns from this invention.

Using simple Gaussian elimination (or another linear system solving/inversion technique) a problem describing a system with at least as many detectors as beams can be solved, as the problem is then mathematically well determined or even over-determined.

Blind deconvolution can be used if no weight factors are known or used, as blind deconvolution estimates unknown weight factors from the data using statistical techniques or Bayesian inference.

It is noted that the weight factors are a function of parameters of the apparatus (beam energy, scan position, etc.) but are also a function of the sample: if for example one beam scans over a heavy metal marker, and the neighboring beam over a light material (for example an organic material or a polymer), the beam hitting the heavy metal generates more backscatters than the other beam. Therefore only using weight factors is only recommended when the sample is more or less homogeneous in type of material (for example organic material).

It is noted that preferably the number M of detectors is equal to or larger than the number of beams.

When the number of detectors is equal to or larger than the number of beams, the problem is mathematically well determined or even over-determined.

It is noted that when the number of detectors is smaller than the number of beams, the problem can still be solved when there is sufficient knowledge of the contribution of the different beams, for example by periodic intensity modulation (e.g. blanking), or one beam scanning at a (much) higher scan rate than the other, so that the contribution of the one beam can be distinguished from the other.

It is further noted that also an apparatus with less detectors than beams is part of the invention. In that case no mathematical solution based on e.g. Gaussian elimination can be used. However, other knowledge of the beams may be available, for example based on experiments, calibration, etc..
One such example occurs when some of the beams scan at a much higher scan rate and a source separation technique (including, but not limited to high frequency/low frequency filtering, integration, or another frequency/space unmixing technique) enables disentanglement of the fast scanned images with respect to the slow scanned images. Another such example is that the contribution of part of the beams is estimated by temporarily blanking (or at least using intensity modulation) of part of the beams. This resembles structured illumination imaging techniques and is also similar to some compressive sensing approaches".

It is further noted that in this context a detector is a surface sensitive to secondary radiation and is not capable of positional information of the impinging secondary radiation. A CMOS sensor with Q pixels is thus seen as Q detectors (when binning the pixels this number is reduced by the binning factor). In this respect it is thus immaterial that not all detectors can be read simultaneously.

Preferably the beams are scanned synchronously.

The beams may have a constant intensity all the time, or they may be blanked simultaneously, or they may be blanked independent from each other.

### Brief description of the drawings

The invention is elucidated using figures, in which identical reference numerals refer to corresponding features. To that end:
Fig. 1 schematically shows a prior art multi-beam microscope (MBM),
Fig. 2 schematically shows a prior art multi-beam electron microscope (MBEM),
Fig. 3 schematically shows MBEM according to the invention.
Fig. 4 schematically shows a detailed view of a detector for use in the MBM or an MBEM,
Fig. 5 schematically shows a detailed view of another detector for use in the MBM or the MBEM.

### Detailed description of preferred embodiments

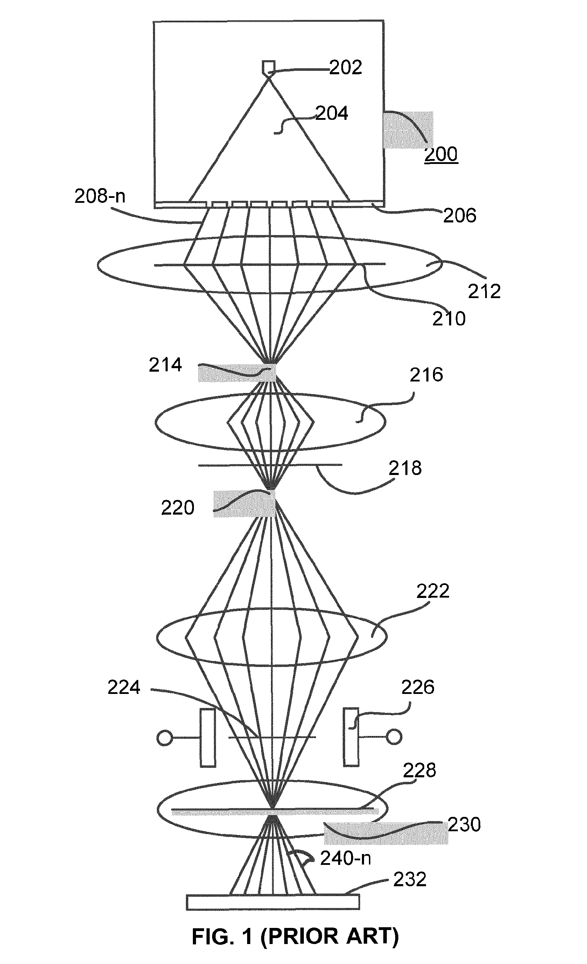

Figure 1 schematically shows a prior art multi-beam electron microscope (MBEM).

A gun module 200 comprises a particle source (electron source) 202 with integrated optics produces a beam of charged particles (electrons) 204, that is split into a multitude of beams 208-m by an array of beam defining apertures in diaphragm 206. The electron source with integrated optics focuses the electron source in plane 210, thus forming an array of images of the electron source, said plane coinciding with an accelerator lens 212. In this lens the beams are accelerated to their final energy. The lens 212 converges the beams to cross-over 214, which cross-over is imaged by lens 216 to another crossover 220. The lens 216 also forms an image of array of electron source images 212 in plane 218. A further lens 222 images the cross-over 220 on cross-over 228 and the array of electron source images 218 on plane 224. Plane 224 coincides with the plane where deflector unit 226 acts (the deflector being either magnetic of electrostatic, or both).The objective lens 230, placed in the cross-over plane 228, forms the final image of the array of electron sources on the sample 232. The column is further equipped with apertures to confine the beam diameter and lens aberration, most specifically an aperture in plane the plane where cross-over 220 is formed. Hereby an array of beams 240-n is formed (in this case 196 = 14 x 14 beams).

The MBEM described here is formed using a specially developed gun module comprising parts 200, 202, 204, 206, and 212, placed on a part of a Nova NanoSEM 200, commercially available from FEI Company. Such a NovaNanoSEM 200 also comprises a secondary electron detector. However, one such detector cannot distinguish between the effect of each of the beams.

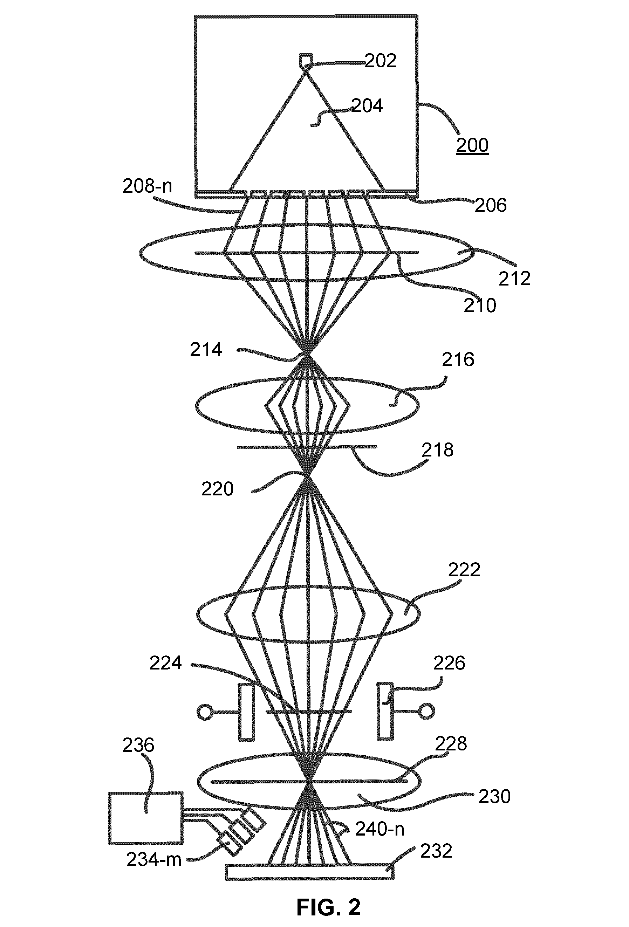

Fig. 2 schematically shows an MBEM according to the invention.

Figure 2 can be thought to be derived from figure 1. Here an array of detectors 234-m is placed between the objective lens 230 and the sample 232. Although each detector is not sensitive to only one beam, but detects radiation resulting from multiple beams, the programmable controller 236 is programmed to reconstruct the contribution of each beam from the signal from each of the detectors.

When the number of detector 234-m equals the number of beams 208-n, or is larger, it is possible to determine the weight factors either experimentally by for example blanking all but one beam and determining the contribution of the single beam to each detector. The problem can also be solved mathematically, for example using Gauss-elimination. This should be done for several scan positions, working distances and beam energies (if applicable). This then leads to the determination of the dynamic weight factors.

When the number of detectors is less than the number of beams, a rigid mathematical solution is not possible. However, if sufficient knowledge of the contribution of the different beams is provided, for example by intensity modulation (blanking), the problem can still be solved. Also having part of the beams scan the sample at a much higher scan rate provides such knowledge, as the signals caused by the high frequency scans can be distinguished from the low frequency scan.

It is noted that, although the invention is explained for an MBEM, the skilled person will recognize that it is equally applicable to (confocal) optical microscopy and ion optics. Also, the beams may be produced by a single source, for example a single electron source, but also by a multitude of sources, for example a multitude of semiconductor lasers or a multitude of electron sources.

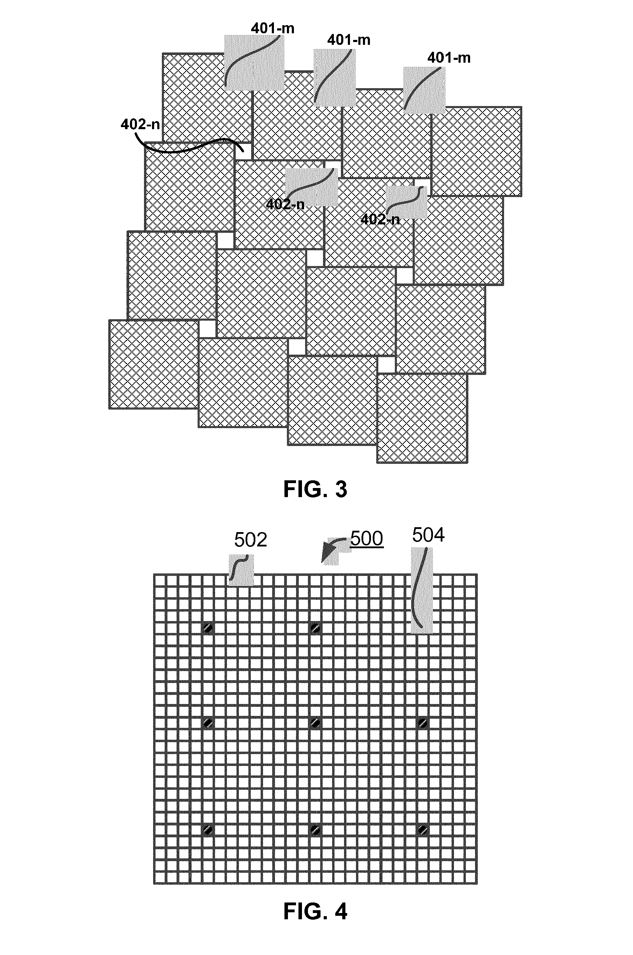

Fig. 3 schematically shows a detailed view of a detector for use in the MBM or an MBEM.

Figure 3 shows a schematic view from the multitude of detectors 402-m as seen from the sample. Each detector is formed as a square detector, for example a PIN diode for detecting photons (light, X-rays) or electrons. Also so-called silicon photo-multiplier (Si-PM), avalanche diodes, etc. can be used. By the lay-out shown in this figure multiple holes 402-n are present, each of these holes available to pass one or more beams.

Fig. 4 schematically shows a detailed view of another detector for use in the MBM or the MBEM.

A CMOS sensor 500 with a multitude of M pixels 502 shows N-holes. Each pixel 502 acts as a separate detector, although part of one chip/wafer. Beams pass through these holes to the sample.

It is noted that multiple beams can be directed to the sample through one hole.

### Cited non-patent literature

[-1-] "Handbook of Blind Source Separation: Independent Component Analysis and Applications", edited by P. Comon and C. Jutten, Academic Press, 2010, 1st edition, ISBN 978-0-12-374726-6.
[-2-] "Independent Component Analysis: Algorithms and Applications", A. Hyvärinen and E. Oja, Neural Networks, Vol. 13(4-5) (2000), p. 411-430.

## Claims

1. A multi-beam apparatus for inspecting or processing a sample (232) with a multitude of focused beams, the apparatus equipped to scan a multitude of N beams (240-n) over the sample, the apparatus equipped with a multitude of M detectors (234-m) for detecting secondary radiation emitted by the sample when said sample is irradiated by the multitude of beams, each of the detectors capable of outputting a detector signal representing the intensity of the secondary radiation detected by the detector, , in working, each detector signal comprising information caused by multiple beams, the information caused by one beam thus spread over multiple detectors, the apparatus equipped with a programmable controller (236) for processing the multitude of detector signals to a multitude of output signals, using weight factors so that each output signal represents information caused by a single beam, **characterized in that** the weight factors are dynamic weight factors depending on the scan position of the beams with respect to the detectors and the distance between sample and detectors.

2. The apparatus of claim 1 in which the beams (240-n) are scanned in unison.

3. The apparatus of any of the preceding claims in which the beams (240-n) are beams from the group of charged particle beams, ion beams and electron beams, or combinations thereof, and the weight factors are further dependent on the beam energies.

4. The apparatus of any of the preceding claims in which the multitude of detectors (234-m) are equipped to detect visible light photons, UV photons, X-ray photons, secondary electrons, backscattered electrons, and/or combinations thereof.

5. The apparatus of any of the preceding claims in which the multitude of beams are generated by a single source (202).

6. The apparatus of any of the preceding claims in which the controller (236) is programmed to perform source separation techniques to process the multitude of detector signals so that each output signal represents information caused by a single beam.

7. The apparatus of any of the preceding claims in which the source separation technique uses solving/inversion techniques and/or Gaussian elimination and/or knowledge of relative detector weight factors and/or blind deconvolution.

8. A method for inspecting or processing a sample (232) with a multi-beam apparatus, the apparatus scanning a multitude of N focused beams (240-n) over the sample, the sample in response to the irradiation with the beams emitting secondary radiation, the secondary radiation detected by a multitude of M detectors (234-m), each of the M detectors outputting a signal representing the intensity of the secondary radiation detected by the detector, the signal of each detector comprising information caused by multiple beams, the information caused by one beam thus spread over multiple detectors, and the information caused by each beam is reconstructed by combining the signal of multiple detectors using weight factors, **characterized in that** the weight factors are dynamic weight factors depending on the scan position of the beams with respect to the detectors and the distance between sample and detectors.

9. The method of claim 8 in which the beams (240-n) are scanned in unison.

10. The method of any of claims 8-9 in which the beams are beams of the group of charged particle beams, ion beams and electron beams, or combinations thereof, and the weight factors are further dependent on the beam energies.

11. The method of any of claims 8-10 in which the secondary radiation comprises visible light photons, UV photons, X-ray photons, secondary electrons, backscattered electrons, and combinations thereof.

12. The method of any of claims 8-11 in which each detector of the multitude of M detectors (234-m) share a similar response to the secondary radiation.

13. The method of any of claims 8-12 in which scanning a multitude of N beams (240-n) over the sample results in irradiating a contiguous area, and thus a contiguous area is imaged.

14. The method of any of claims 8-13 in which the beams are emitted by one source (102).

15. The method of any of claims 8-14 in which the reconstruction is performed using source separation techniques.

16. The method of any of claims 8-15 in which the source separation techniques uses linear system solving/inversion techniques and/or Gaussian elimination and/or knowledge of relative detector weight factors and/or blind deconvolution.
